# EUROPEAN PATENT APPLICATION

(11) **EP 1 518 634 A1**
(43) Date of publication of application: **30.03.2005**
(21) Application number: 03078008.4
(22) Date of filing: 23.09.2003
(51) Int. Cl.: B23K 26/40, H01L 21/78, B23K 26/04

(54) **A method of and a device for separating semiconductor elements formed in a wafer of semiconductor material**

(71) Applicant: Advanced Laser Separation International (ALSI) B.V., 6641 TL, Beuningen (NL)
(72) Inventor: Chall, Hans Peter, 6641 TL Beuningen (NL); Smits, Wilhelmus Hubertus, 6641 TL Beuningen (NL); Van Panhuys, Haro Egbert Georg Roderik, 6641 TL Beuningen (NL)
(74) Representative: Dohmen, Johannes Maria Gerardus

(57) **Abstract**

The present invention relates to a method of separating semiconductor elements formed in a wafer of semiconductor material using a laser producing a laser beam. Said wafer and said laser beam are relatively moved for separating said semiconductor elements along a path while said laser is repeatedly fired for producing spots of removed wafer material. The relative movement of the wafer and the laser beam and the firing of the laser are controlled such that a laser beam travelling the same path impinges on said wafer at said spots. The invention also relates to a device arranged for performing the above method, as well as a wafer comprising scores formed with the above method or by the device mentioned.

## Description

### Field of the Invention

The present invention relates generally to the processing of semiconductor material and, more specifically, to the separation of semiconductor elements formed in a wafer of semiconductor material.

### Background of the Invention

Semiconductor elements formed in wafer of semiconductor material such as diodes, transistors, integrated circuits comprising a plurality of diodes and transistors and passive components, such as capacitors, are generally separated from each other by laser dicing or laser cutting techniques.

U.S. patent 5,922,224 assigned to the assignee of the present patent application, discloses a laser separation technique whereby a score is formed in a surface of a wafer of semiconductor material by local evaporation of semiconductor material through heating by means of radiation generated by a laser. During the formation of the score, the wafer is moved relative to the radiation of the laser directed to the wafer along a path which follows the score to be formed.

That is, the wafer may be moved while the laser or an optical system by which the laser energy is directed to the wafer remains stationary, or the laser or the optical system may be moved while the wafer remains stationary. It will be appreciated that both the wafer and the laser or the optical system may be moved simultaneously or alternately, for example.

The score is formed in lanes of untreated semiconductor material, i.e. wherein no semiconductor elements are formed, also called separation lanes. The score may be formed by means of a laser which continuously emits radiation onto the wafer or in a pulsatory manner. In the latter case, a score is formed consisting of a plurality of spaced apart holes or spots of removed semiconductor material.

In practice, the energy of the laser radiation directed to the wafer and the time during which the laser radiation is focussed on a particular spot have to be limited. Among others, for avoiding overheating and thereby damaging of the adjacent semiconductor elements on the wafer. On the other hand, the holes or spots have to formed with a predetermined depth, in order to avoid breakage of the semiconductor wafer along a breaking line running trough a semiconductor element, which unduly would reduce the yield of the wafer. The required depth of the holes or spots depends, inter alia, on the thickness and the composition of the wafer material.

As disclosed in the above-mentioned US patent 5,922,224 a deeper score, i.e. deeper holes or spots, can be achieved in that the laser radiation is aimed at the wafer in two ore more beams, such that the beams travel the same path in one or more passes. The laser beams are repeatedly produced with a predetermined fixed time interval, the duration of which is selected, among others, such that a gas cushion formed by evaporation of semiconductor material is disappeared before the next beam arrives at the spot. The formation of such a gas cushion counteracts the evaporation of semiconductor material and thereby the deepening of the hole or spot.

It is found in practice, however, that the laser and wafer position are not stable over time. For making holes of a required depth, the laser beams should impinge on the wafer at the same spots as exactly as possible, in order to avoid widening of the spots or holes instead of deepening thereof.

### Summary of the Invention

It is an object of the present invention to provide an improved method of separating semiconductor elements formed in a wafer of semiconductor material, wherein a laser emits radiation onto the wafer in a pulsatory manner.

It is a further object of the present invention to provide an improved device for separating semiconductor elements formed in a wafer of semiconductor material, wherein a laser emits radiation onto the wafer in a pulsatory manner.

In a first aspect according to the present invention there is provided an improved method of separating semiconductor elements formed in a wafer of semiconductor material using a laser producing a laser beam, the wafer and the laser beam being relatively moved for separating the semiconductor elements along a path while the laser is repeatedly fired for producing spots of removed wafer material, wherein the relative movement of the wafer and the laser beam and the firing of the laser are controlled such that a laser beam travelling the same path impinges on the wafer at said spots.

The improved method according to the invention is based on the insight that by making the firing of the laser dependent from the relative movement and position of the wafer and the laser beam such that the laser beam, when being fired, hits the semiconductor wafer each time as exactly as possible on the same spots, widening of a spot is as much as possible prevented.

That is, different from the prior art of record, in the method according to the invention, the laser is not fired with a predetermined fixed repetition rate for each subsequently travelled path. Firing of the laser in accordance with the present invention is made dependent form the positioning of the laser and the wafer after being moved. Variations in wafer-table position and wafer-table speed or variations in laser position and speed or the position and speed of an optical system by which the laser beam is produced, will not lead to local capability variations of the separation process, others than intended by process control.

Those skilled in the art will appreciate that, in the case of removing semiconductor material of the substrate by means of evaporation, the firing time of the laser is also controlled such that the formation of gas cushions will not absorb radiation energy directed onto the wafer.

With the improved method according to the invention, the depth of the holes or spots can be precisely controlled. Accordingly, separation lanes symmetrically positioned over the wafer substrate can be formed having equal properties as regard to the depth of the holes or spots of a separation lane. Herewith, when breaking up a semiconductor wafer into separate semiconductor elements, an as even as possible force distribution can be achieved over the substrate, avoiding breakage of the substrate locally over a breaking surface running through a semiconductor element as a result of an uneven or non-symmetric force distribution caused by holes or spots of different depths.

Those skilled in the art will appreciate that the method according to the invention can be applied to a plurality of different laser separation techniques for separating semiconductor elements formed in a wafer of semiconductor material, using the principle of evaporation, ablation or any other manner of removing wafer material by radiation energy.

The improved method according to the invention can be used with a single laser producing a single beam, a single laser producing a plurality of beams, a plurality of lasers each producing a single beam, and a plurality of lasers at least one of which producing a plurality of laser beams.

In a further embodiment of the method according to the invention, wherein a plurality of laser beams is used for forming the scores, the laser beams are produced for travelling the same path one after the other, and the relative movement between the wafer and the laser or lasers producing the laser beams and the firing thereof are controlled such that the laser beams hit the surface of the wafer substrate as exactly as possible on the spots or holes formed therein.

By using a plurality of beams arranged for travelling the same path one after the other sufficiently deep holes or spots can be formed in a single pass along a separation lane.

In a yet further embodiment of the method according to the invention, using a plurality of laser beams for forming the scores, the laser beams are produced for travelling adjacent paths, and the relative movement between the wafer and the laser or lasers producing the laser beams and the firing thereof are controlled such that the laser beams hit the surface of the wafer substrate as exactly as possible on the spots or holes formed therein.

By this embodiment of the invention, a plurality of separation lanes can be travelled simultaneously.

In both cases, the firing of the laser or lasers may be controlled such that a particular laser beam impinges solely on the spot or spots made by this particular beam, or in that any beam may hit any of the spots formed on the surface, or combinations thereof. In a single or multiple passes along separation lanes on the wafer substrate.

If a laser beam has to pass multiple times over a scribing or separation lane in order to create full separation. In an embodiment of the invention, a laser beam will therefore travel along a path in the separation lane back and forth one or more times, and proceed with a next path in another separation lane. The wafer will in this case be processed by following a relative I-type movement.

In a preferred embodiment of the method according to the invention, in each pass a path is travelled by a laser beam in a same direction.

With this embodiment of the invention, small unknown delay times encountered in practice in laser and steering electronics, resulting in small 1 variations in the position where the laser beam will hit the wafer surface, each time a next pass is started, are eliminated if the lane is passed always in the same direction.

To this end, the wafer table or the laser or laser optics have to make a return movement before starting the next pass over the already processed separation lane.

In a yet further embodiment of the method according to the invention, this return movement is advantageously used by travelling adjacent or parallel paths in opposite directions with respect to each other, however such that each path is travelled in the same direction.

As a result, the wafer will be processed in that adjacent or parallel paths are travelled by a relative U-type movement of the wafer and laser beam or laser beams.

In another embodiment of the invention, at least two paths of a plurality of parallel paths in parallel separation lanes on said wafer are travelled subsequently and one or more paths are comprised in between said subsequently travelled paths.

A laser beam will in this case, for instance, skip a number of paths adjacent to the path that has been processed, before a next parallel path is travelled. An advantage of this embodiment is that the thermal load to the wafer, caused by firing the laser onto the surface, is spread over the surface. This reduces the risk of damaging the semiconductor elements on the wafer.

In a second aspect according to the invention, there is provided a device for separating semiconductor elements formed in a wafer of semiconductor material, the device comprises a laser for producing a laser beam, firing means for repeatedly firing the laser for producing the laser beam, a table for receiving the wafer, means for providing a controlled relative movement of the table and the laser beam along a path for separating the semiconductor elements from the wafer, and wherein the firing means are arranged for firing the laser for producing spots of removed wafer material by the laser beam, and measuring means for measuring the relative position of the table and the laser beam, wherein the measuring means are arranged for providing a trigger for firing the laser, such that a laser beam travelling the same path impinges on the wafer at said spots.

With the device according to the invention, after each movement the relative position of the table and the laser beam is measured and the trigger pulse for firing the laser is generated if the laser beam and the wafer are positioned such that the laser beam hits as exactly as possible the wafer surface at the spots already made therein.

In further embodiments of the invention, the device according to the invention can be advantageously arranged for firing a laser or a plurality of lasers producing a single or a plurality of laser radiation beams directed towards a wafer surface, by generating suitable trigger pulses dependent on the relative position of the wafer and the laser or laser optics producing a laser beam. The laser beams may be arranged for travelling a separation lane one after the other and/or next or adjacent to each other in a single or multiple passes.

In a further embodiment of the invention, the means for controlling the movement of the wafer table and a laser beam are arranged for travelling a separation lane in each pass back and forth, providing a relative I-type movement. This ensures that the end-point of the forth going movement of the laser beam is the starting point of the back going movement of the laser beam along the path.

In a further embodiment of the device according to the invention, the means for controlling the movement of the wafer table and a laser beam are arranged for travelling a separation lane in each pass in the same direction. By providing a relative U-type movement of the wafer and laser beam or laser beams, adjacent or parallel lanes are advantageously travelled in mutual opposite directions.

In a third aspect, the invention relates to a wafer of semiconductor material comprising semiconductor elements, the wafer comprising scores formed in accordance with the method or device according to the invention as disclosed above.

In an embodiment thereof said wafer is further coated by a substrate or mould for forming a package. Advantageously, the invention may be applied to separating or cutting wafer packages as described.

The above-mentioned and other features and advantages of the invention are illustrated by way of example and in a non-imitative manner in the following description with reference to enclosed drawing.

### Brief Description of the Drawings

Fig. 1 shows, in a schematic manner, a portion of a semiconductor wafer in which semiconductor elements are formed in accordance with the prior art.
Fig. 2 shows in, a schematic manner, the improved method according to the present invention.
Fig. 3 shows, in a schematic manner, an embodiment of a device arranged for performing the method according to the present invention, producing spatially separated laser beams from a single laser light source.

### Detailed Description of Embodiments

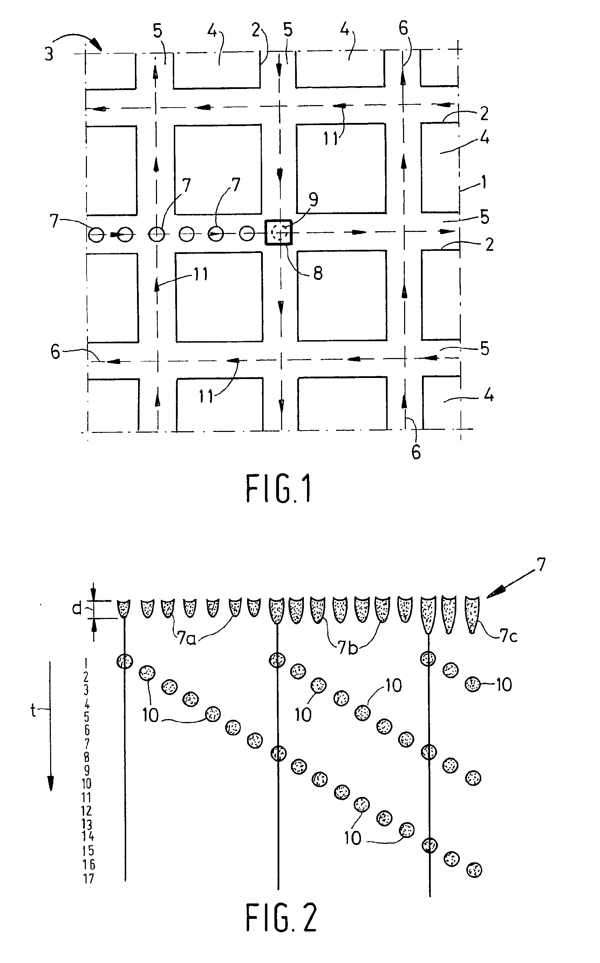

Fig. 1 shows part of a wafer 1 of semiconductor material in elevation. Typically, wafers 1 have a thickness of approximately 100-120 µm in which semiconductor elements 2 are formed from a surface 3 of the wafer 1 in a known manner. The semiconductor elements 2 may comprise single semiconductor devices such as diodes, transistors and the like, but also integrated circuits comprising a plurality of semiconductor elements. For the purpose of the present description, the term semiconductor element has to be construed as comprising semiconductor integrated circuits. In the case of single semiconductor elements 2, such as diodes, typical dimensions of the surfaces 4 of the semiconductor elements 2 are 240 x 240 µm. However, the present invention is not limited to these dimensions, as will be appreciated by those skilled in the art.

The semiconductor elements 2, in accordance with the prior art disclosed above, are separated from each other by lanes 5 of untreated, i.e. not processed, semiconductor material. The elements 2 are separated from the wafer 1 by subdividing the wafer 1 into pieces along the lanes 5. In this example, a score 7 is formed along a path 6 in each lane 5. Such a score 7 may cut through the entire thickness of the wafer 1, or only through part of the thickness of the wafer 1. After having formed the scores 7, the wafer 1 is broken up into pieces by ultrasonic vibration, for example.

As shown in Fig. 1, the scores 7 are formed by a series of adjacent spots of removed wafer material. The wafer material is removed using a laser light source 8 producing a laser beam 9 which is focussed onto the surface 3 of the wafer 1 by an optical system (not shown). The laser 8 is repeatedly fired while the laser 8 and/or its focussed beam 9 travel along a path 6. Alternatively, the wafer 1 may be moved while the laser 8 and/or the beam 9 are kept stationary, or both the wafer 1 and the laser 8 and/or the beam 9 may be moved all together. As an example, the laser 8 may be a pulsed Q-switch YAG laser by which a laser beam having a radiation wavelength of about 1 µm is generated.

Fig. 2 shows in a schematic manner the method according to the present invention, for separating semiconductor elements 2 from the wafer 1. In the upper part of Fig. 1, a plurality of scores 7a, 7b and 7c are shown, the depth, d, of which increases in the direction from left to right in the plane of the drawing. That is scores 7c are deeper than scores 7b which are deeper than scores 7a.

In accordance with the present invention, in order to provide scores 7 of sufficient depth while using a laser 8 of limited power, the laser beam 9 has to impinge several times on a spot 10 in order to remove a sufficient amount of wafer material required for safely breaking up the wafer 1. The number of times the laser 8 is fired is indicated by a so-called "shot" number 1, 2, 3, ... etc. drawn along a time axis t. In the plane of the drawing, the time axis t runs from top to bottom, i.e. in the vertical direction.

As can be seen from Fig. 2, in the example shown, after seven firing shots the laser beam impinges on a previously formed spot 10, thereby each time deepening the score 7 formed. From a practical point of view, it is not efficient to put the laser 8 and/or the laser beam 9 in a stationary position with respect to the wafer 1, and firing the laser 8 several times on the same spot 10, because each time the laser 8 is fired and wafer material is removed, a gas cushion is formed from evaporation of the wafer material, which gas cushion partly absorbs the radiation of the laser 8.

In order to improve the cutting process efficiency, the laser 8 and/or the laser beam 9 and the wafer 1 are moved with respect to each other, such that the laser 9 can be fired for forming a score 7 at a next spot 10, while the gas cushion or cushions formed at the previous spot or spots of the wafer 1 may disappear. However, in order to avoid widening of the spots 10, at least to the extend that the spots 10 and the scores 7 formed remain within the lanes 5, the relative movement of the wafer 1, the laser 8 and/or the beam 9 and the firing time of the laser 8 are controlled and synchronized such that an efficient and effective cutting process is provided, both in speed of operation and enhanced quality and depth of the scores formed. The laser 8 is fired whenever the laser beam 9 is accurately positioned, such that the laser beam 9 travelling a same path 6 impinges as exact as possible on the spots 10 already formed, thereby avoiding widening of the spots 10 produced by the laser beam 9.

The risk of damaging due to overheating of the wafer 1 and the semiconductor elements 2 is greatly reduced because the cutting process according to the present invention can be performed using laser devices of less optical power, compared to the prior art of record. For example, scores 7 having a depth of 150 µm can be formed by 6 shots fired at a particular spot 10 using a infra-red (IR) laser of 10 Watt.

Another effective method of reducing the risk of damage due to overheating of the wafer is achieved by spreading the thermal load of the process over the surface of the wafer. This can be done moving the laser beam to a next path each time that a path has been travelled by the laser beam. This next path may be an adjacent path in an adjacent separation lane. It is however even more effective to skip a number of lanes and move the laser beam to a lane on a certain distance from the path just travelled, such that a number lanes are in between. The thermal load will then be distributed over the surface.

Instead of using a single laser beam 9, the method according to the present invention can also be performed using multiple spatially separated laser beams 9, which are simultaneously, relatively moved with respect to the wafer 1. The laser beams 9 may be arranged for travelling a same path 6 one after the other. The spatially separated laser beams 9 may also be arranged for travelling adjacent paths 6, i.e. paths 6 situated in different lanes 5. However, in accordance with the invention, it is also possible to form scores 7 adjacent to each other in a particular lane 5, without an undue risk of damage of semiconductor elements 2 formed in the wafer 1, because of the controlled and synchronized manner of positioning and firing of the laser 8. Preferably, the laser 8 and/or the laser beam 9 and the wafer 1 are moved with respect to each other by travelling a path 6 in multiple passes.

In a preferred embodiment of the invention, in view of tolerances in the positioning equipment of the wafer 1, delays in control and steering electronics and the like, which may result in small variations in the positioning of a laser beam, it is very advantageous to travel a path 6 always in or from the same direction, such as indicated by the arrows 11 in Fig. 1. By approaching a spot position from the same direction, the positioning and steering tolerances each time will be equal, such that the laser beams will exactly impinge on a corresponding spot 10 previously formed.

In accordance with a further embodiment of the present invention, adjacent lanes 5 are travelled in opposite directions with respect to each other, advantageously continuous U-type movements of the wafer 1 or the laser 8 and/or the laser beam or beams 9 can be made, without actually having to stop the movement for travelling back and forth a particular lane 5, for example. It has been proven that with a continuous relative movement enhanced positioning accuracy can be obtained.

It is noted here, that the use of a relative I-type movement, wherein a laser beam will travel along a path in the separation lane back and forth one or more times before proceeding with a next path in another separation lane, may also provide advantages. A person skilled in the art may understand that by providing said I-type movement, it is ensured that the end-point of the forth going movement of the laser beam is exactly the starting point of the back going movement of the laser beam along the path. Some embodiments of the invention may therefore be directed to applications using said I-type movement, without leaving the scope of the invention.

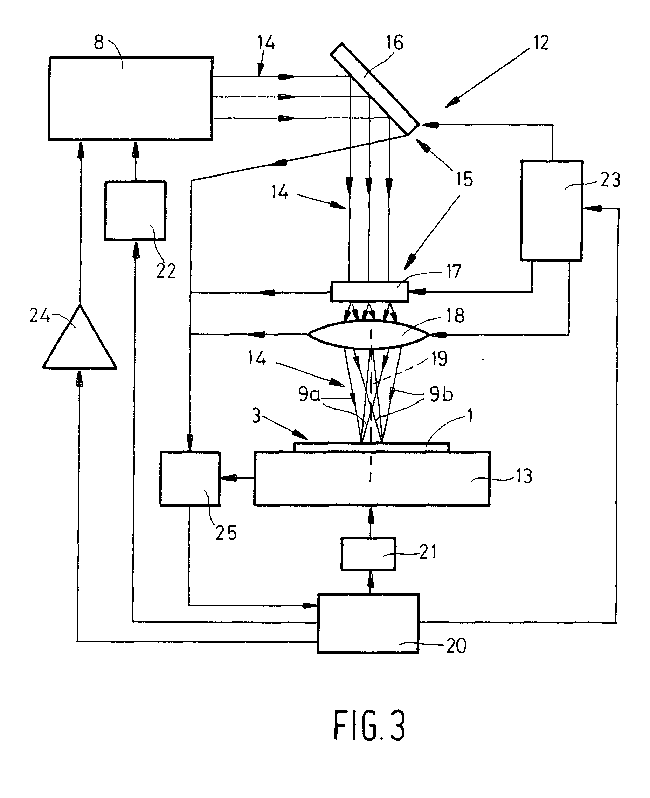

Fig. 3 schematically shows a device 12 for producing two spatially separated laser beams 9a, 9b, to be directed onto a surface 3 of a wafer 1. The wafer 1 is positioned on a table 13 which can be moved relative to the laser beams 9a, 9b and/or the laser light source 8. The spatially separated laser beams 9a, 9b are provide from radiation 14 leaving the laser 8 and which is aimed at the surface 3 of the wafer 1 by an intermediate optical system 15.

In the embodiment shown, the optical system 15 comprises a mirror 16 which deflects light or radiation 14 from the laser 8 at an angle of 90° onto a binary diffraction grating 17, which splits the radiation 14 into the two beams 9a and 9b, respectively, and a lens 18 focussing the beams 9a and 9b onto the surface 3 of the wafer, for producing scores 7, i.e. spots 10. A suitable optical system 15 having an optical axis 19 for use with the present invention is disclosed and described in the prior art document US 5, 922, 224 of the same Assignee as the present application, which prior art document is herein incorporated by reference.

The table 13 and the laser 8 and/or the optical system 15 are coupled to means 20 for providing a controlled relative movement of the coupled devices. The means 20, in their most general form, control table drive means 21 for moving the table 13, laser drive means 22 for moving the laser 8 and optical system drive means 23 for driving the optical system 15 or part thereof for moving the laser beams 9a, 9b, if applicable. The means 20 comprise suitable electronic control means, preferably in the form of a digital software controlled (micro) processor for controlling the relative movement and for triggering laser firing means 24, for firing the laser 8 in a synchronized manner with the positioning of the laser beams 9a, 9b relative to the wafer 1 as measured by position measuring means 25, in accordance with the method of the invention disclosed above. The measuring means 25 comprise encoders and sensors for sensing the position of either one or all of the movement and adjustment of the table 13, the laser 8 and/or the optical system 15

Suitable measuring means 25 and drive means 21, 22, 23 for the purpose of the present invention are known to those skilled in the art and need no further explanation here. The software control program for controlling the means 20, for processing measured results and for firing the laser 8 are the property of the present invention. Note that, for the purpose of the present invention, it is sufficient to control movement of just one of the table 13, the laser 8 or the optical system 15, in order to repeatedly impinge radiation on a particular spot 10.

The control means 20, in particular the software control program, are arranged to take into account as much as possible tolerances, delays, etc. in the drive means 21, 22, 23, the firing means 24 and the measuring means 25, as well as internal delays etc. in the control means 20 themselves, for the purpose of the present invention.

It will be appreciated by those skilled in the art, that the optical system 15 is optional and the cutting process in accordance with the present invention can be performed by a single laser beam 9 from a single laser light source 8.

In a more sophisticated embodiment of the invention, multiple laser light sources 8 may be used, operating simultaneously on a wafer 1, for example producing multiple laser beams as shown in fig. 3. Each of such lasers 8 and optical systems 15, if applicable, may be driven independently, by separate control an drive means, or integrally using single motion control means 20, for example.

The present invention includes wafers 1 subjected to a cutting process according to the invention, as disclosed above,

The invention is, of course, not limited to the disclosed and described embodiments. A skilled person may modify the method steps and the device components within the spirit and scope of the present invention as disclosed in the attached claims, which comprise all such amendments and modifications.

## Claims

1. A method of separating semiconductor elements formed in a wafer of semiconductor material using a laser producing a laser beam, said wafer and said laser beam being relatively moved for separating said semiconductor elements along a path while said laser is repeatedly fired for producing spots of removed wafer material, **characterized in that** said relative movement of said wafer and said laser beam and said firing of said laser are controlled such that a laser beam travelling the same path impinges on said wafer at said spots.

2. A method according to claim 1, wherein at least two spatially separated laser beams are produced by a said laser, and said relative movement of said wafer and said laser beams and said firing of said laser are controlled such that said laser beams travelling the same path impinge on said wafer at said spots.

3. A method according to any of the previous claims, wherein at least two spatially separated laser beams are produced by at least two lasers, and said relative movement of said wafer and said laser beams and said firing of said lasers are controlled such that said laser beams travelling the same path impinge on said wafer at said spots.

4. A method according to claim 2 or 3, wherein said laser beams are produced for travelling the same path one after the other.

5. A method according to claim 2, 3 or 4, wherein said laser beams are produced for travelling adjacent paths.

6. A method according to any of the previous claims, wherein a path is travelled back and forth by said laser beam, forming a relative I-type movement.

7. A method according to any of the previous claims, wherein a path is travelled by a laser beam in multiple passes.

8. A method according to claim 7, wherein in each pass a path is travelled by a laser beam in a same direction.

9. A method according to claim 7 or 8, dependent from claim 1, 2, 3 or 4, wherein paths that are travelled subsequently are travelled in opposite directions.

10. A method according to claim 9, wherein said subsequently travelled paths are travelled by a relative U-type movement of said wafer and a laser beam.

11. A method according to claim 9 or 10, wherein said subsequently travelled paths are adjacent paths.

12. A method according to any of the previous claims, wherein at least two paths of a plurality of parallel paths on said wafer are travelled subsequently and wherein one or more paths are comprised in between said at least two paths.

13. A device for separating semiconductor elements formed in a wafer of semiconductor material, said device comprises a laser for producing a laser beam, firing means for repeatedly firing said laser for producing said laser beam, a table for receiving said wafer, means for providing a controlled relative movement of said table and said laser beam along a path for separating said semiconductor elements from said wafer, and wherein said firing means are arranged for firing said laser for producing spots of removed wafer material by said laser beam, **characterized by** measuring means for measuring relative position of said table and said laser beam, wherein said measuring means are arranged for providing a trigger for firing said laser, such that a laser beam travelling the same path impinges on said wafer at said spots.

14. A device according to claim 13, wherein said laser is arranged for producing at least two spatially separated laser beams, and said means for providing said controlled movement of said table and said laser beams and said firing means of said laser are controlled such that said laser beams travelling the same path impinge on said wafer at said spots.

15. A device according to any of the claims 13 or 14, wherein least two lasers are provided and arranged for producing at least two spatially separated laser beams, and said means for providing said controlled movement of said table and said laser beams and said firing means of said lasers are controlled such that said laser beams travelling the same path impinge on said wafer at said spots.

16. A device according to claim 14 or 15, wherein said laser or lasers are arranged for producing said laser beams for travelling the same path one after the other.

17. A device according to claim 14, 15 or 16, wherein said laser or lasers are arranged for producing said laser beams for travelling adjacent paths.

18. A device according to any of the claims 13-17, wherein said means for providing said controlled movement of said table and said laser beam are arranged such that a path is travelled by a laser beam in both directions, forming a relative I-type movement of said table and said laser beam.

19. A device according to any of the claims 13-18, wherein said means for providing said controlled movement of said table and said laser beam are arranged such that a path is travelled by a laser beam in multiple passes.

20. A device according to claim 19, wherein said means for providing said controlled movement of said table and said laser beam are arranged such that in each pass a path is travelled by a laser beam in a same direction.

21. A device according to claim 19 or 20, dependent from claim 13, 14, 15 or 16, wherein said means for providing said controlled movement of said table and said laser beam are arranged such that subsequently travelled paths are travelled in opposite directions by a laser beam.

22. A device according to claim 21, wherein said means for providing said controlled movement of said table and said laser beam are arranged such that subsequently travelled paths are travelled by a relative U-type movement of said table and a laser beam.

23. A device according to claim 21 or 22, wherein said subsequently travelled paths are adjacent paths.

24. A device according to any of the claims 13-23, wherein said means for providing said controlled movement of said table and said laser beam are arranged such that at least two paths of a plurality of parallel paths on said wafer are travelled subsequently, wherein said at least two paths are spaced apart such that one or more paths are comprised in between said at least two paths.

25. A wafer of semiconductor material comprising semiconductor elements, said wafer comprising scores formed in accordance with any of the previous claims.

26. A wafer according to claim 25, wherein said wafer is further coated by a substrate or mould for forming a package.
